# EUROPEAN PATENT SPECIFICATION

(11) **EP 1 900 098 B1**
(45) Date of publication and mention of the grant of the patent: **04.06.2014**
(21) Application number: 06765981.3
(22) Date of filing: 30.06.2006
(51) Int. Cl.: H03K 23/44, H03K 23/54

(54) **MULTI-PHASE FREQUENCY DIVIDER**
MEHRPHASEN-FREQUENZTEILER
DIVISEUR DE FREQUENCE MULTIPHASE

(30) Priority: 30.06.2005 US 696489 P
(43) Date of publication of application: 19.03.2008
(73) Proprietor: Nytell Software LLC, Wilmington DE 19808 (US)
(72) Inventor: SONG, Wenyi, NL-5621 BA Eindhoven (NL)
(74) Representative: Ablett, Graham Keith
(86) International application number: PCT/IB2006/052217
(87) International publication number: WO 2007/004183

(56) References cited:
- EP-A1- 0 926 832
- GB-A- 2 066 988
- KADO Y ET AL: "3.2 GHZ, 0.2 PM GATE CMOS 1/8 DYNAMIC FREQUENCY DIVIDER" ELECTRONICS LETTERS, IEE STEVENAGE, GB, vol. 26, no. 20, 27 September 1990 (1990-09-27), pages 1684-1686, XP000109424 ISSN: 0013-5194
- KADO Y ET AL: "An Ultralow Power CMOS/SIMOX Programmable Counter LSI" IEEE JOURNAL OF SOLID-STATE CIRCUITS, IEEE SERVICE CENTER, PISCATAWAY, NJ, US, vol. 32, no. 10, October 1997 (1997-10), XP011060578 ISSN: 0018-9200

## Description

The present invention relates to electronic digital circuitry, and more particularly to multi-phase frequency dividers.

In the past, single-frequency, single-phase digital clocks were used in computers and a variety of electronic devices. Generating or synthesizing such clocks directly or with phase locked loops (PLL's) and dividers has been straightforward and the technical art is highly developed.

New types of processors and power converters are making novel uses of multi-phase clocks, and these generally require two-phase, three-phase, four-phase, and five-phase clocks with evenly distributed phases. Such multiphase clocks can be produced directly by an oscillator. Geerjan Joordens and the present inventor, Wenyi Song, describe a multiphase ring oscillator in United States Patent Application Publication, US 2004/0032300 A1, published Feb. 19, 2004.

Such multiphase ring oscillator places an even-number of cross-coupling transistors and inverters end-to-end in a ring configuration. The output phases are tapped at the output of each inverter. Four such inverters will produce a four-phase output. Odd numbers of inverters cannot be used because the total phase shift around the loop is not 360-degrees.

A way to generate an odd-number of multiphase clocks with equally spaced phases is with a divider. Externally generated and precision reference clock sources can then be used to synthesize multiphase clocks. One example is the divider used to generate three-phase clocks in the Philips Trimedia Processor.

Digital frequency dividers are used in computer and communications circuits to synthesize various utility clocks from a reference oscillator. A digital frequency divider takes a clock signal "cki" as the input, and outputs a new clock signal "cko". The frequency of cko is the frequency of cki divided by an integer. Such dividers can be implemented in logic as fixed divisor divide-by-n, or programmable divisor divide-by-m.

Synchronous-type dividers and counters clock all the memory elements in parallel with one clock. Programmable digital frequency dividers can be implemented with finite-state-machines (FSM), e.g., with pencil-and-paper, or using logic synthesis tools such as Synopsys Design Compiler. Direct digital synthesis (DDS) is another method, it uses an accumulator clocked by an input cki. During every input clock cycle, the accumulator adds a fixed integer "P" to its content. A number "P" can be selected such that at the end of every "N" input clock cycles, the accumulator overflows. Thus the overflow output functions as the output "cko" of the frequency divider.

Asynchronous-type dividers and counters use a clock to trigger the first flip-flop in a chain, and then the Q-outputs of previous stages are used to clock the next succeeding stages. For example, ripple, decade, and up-down counters employ asynchronous techniques.

Briefly, a multi-phase frequency divider embodiment of the present invention comprises dynamic inverters connected in a ring and the intermediate nodes around the ring are stabilized with cross-coupled latches.

An advantage of the present invention is a multi-phase digital frequency divider is provided.

A further advantage of the present invention is a digital frequency divider is provided that can be implemented with a minimum number of transistors.

A still further advantage of the present invention is that a divider is provided that can be expanded to divide by any even number integer.

The above and still further objects, features, and advantages of the present invention will become apparent upon consideration of the following detailed description of specific embodiments thereof, especially when taken in conjunction with the accompanying drawings.
Fig. 1 is a schematic diagram of a dynamic inverter embodiment of the present invention useful as a first building block in a multi-phase frequency divider;
Fig. 2 is a schematic diagram of a nmos cross-latch embodiment of the present invention useful as a second building block in a multi-phase frequency divider;
Fig. 3 is a schematic diagram of a multi-phase frequency divider embodiment of the present invention in a representative divide-by-four implementation;
Fig. 4 is a diagram of various key waveforms measured for a prototype implementation of the divider of Fig. 3;
Fig. 5 is a schematic diagram of a dynamic inverter embodiment of the present invention with pmos and nmos parts useful as third and fourth building blocks in a simplified multi-phase frequency divider;
Fig. 6 is a schematic diagram of a pmos cross-latch embodiment of the present invention useful as a fifth building block in a simplified multi-phase frequency divider;
Fig. 7 is a schematic diagram of a simplified multi-phase frequency divider embodiment of the present invention in a representative divide-by-four implementation that improves over that illustrated in Fig. 3;
Fig. 8 is a diagram of various key waveforms measured for a prototype implementation of the divider of Fig. 7; and
Fig. 9 is a schematic diagram of a divide-by-two multi-phase frequency divider embodiment of the present invention with quadrature outputs and that uses only twelve transistors.

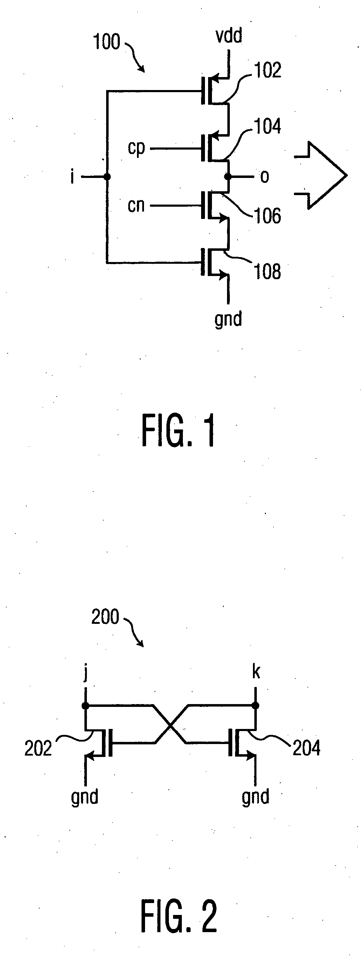

Fig. 1 represents a dynamic inverter embodiment of the present invention, and is referred to herein by the general reference numeral 100. The dynamic inverter 100 is connected between a power rail (vdd) and ground (gnd), and includes an input (i), a clock positive input (cp), a clock negative input (cn), and an output (o). It is constructed with four transistors, two pmos types 102 and 104, and two nmos types 106 and 108. When a clock "cp" is low, and its complement "cn" is high, the output of the inverter is the complement of its input. When "cp" is low and "cn" is high, the output will be in a high impedance state.

Fig. 2 represents a second building block, a cross-latch embodiment of the present invention, and is referred to herein by the general reference numeral 200. The cross-latch 200 comprises cross-connected transistors 202 and 204. The two "j" and "k" nodes will latch complementary values.

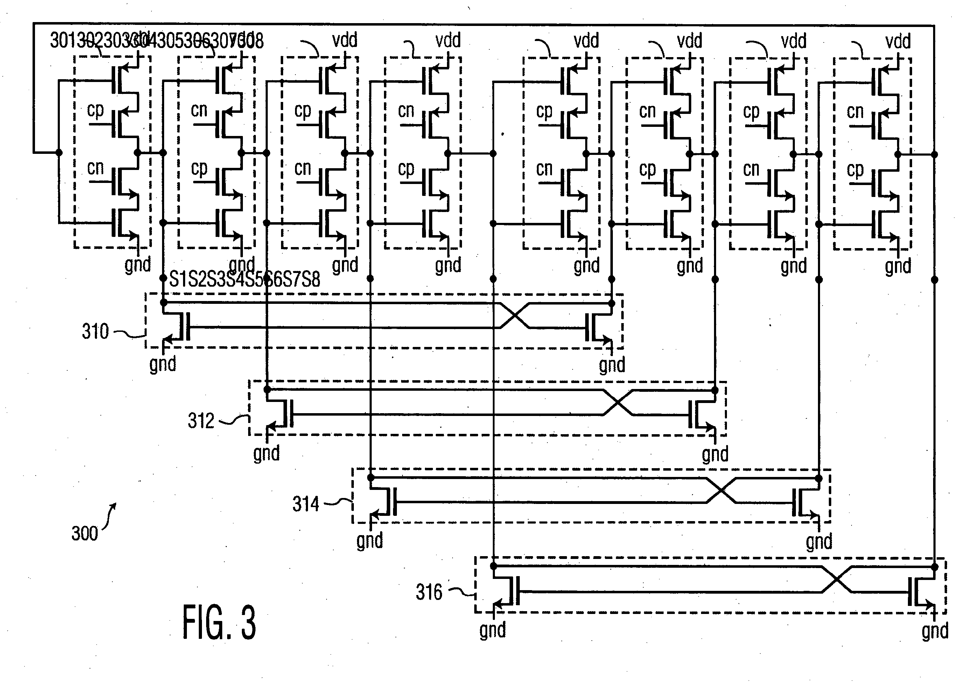

Fig. 3 represents a divide-by-four multi-phase frequency divider embodiment of the present invention, and is referred to herein by the general reference numeral 300. It can be constructed with the two building blocks illustrated in Figs. 1 and 2, e.g., dynamic inverter 100 and cross-latch 200. Inverters 301-308 are connected head-to-tail in a ring. The input clocks "cp" and "cn" are reversed at every other inverter. Four latches 310, 312, 314, and 316 are connected, respectively, to latch the outputs of complementary pairs of inverters 301 and 305; 302 and 306; 303 and 307; and, 304 and 308. These force, or initialize, the proper states around the ring. The multiphase outputs are S1-S4 and their corresponding complements S5-S8.

Divider 300 can be modified by changing the number of inverters in the ring to divide by any even integer "E". The total number of inverters in the ring will be 2*E, with E-number of cross-connected latches. The multiphase outputs will always be evenly distributed for any divisor E.

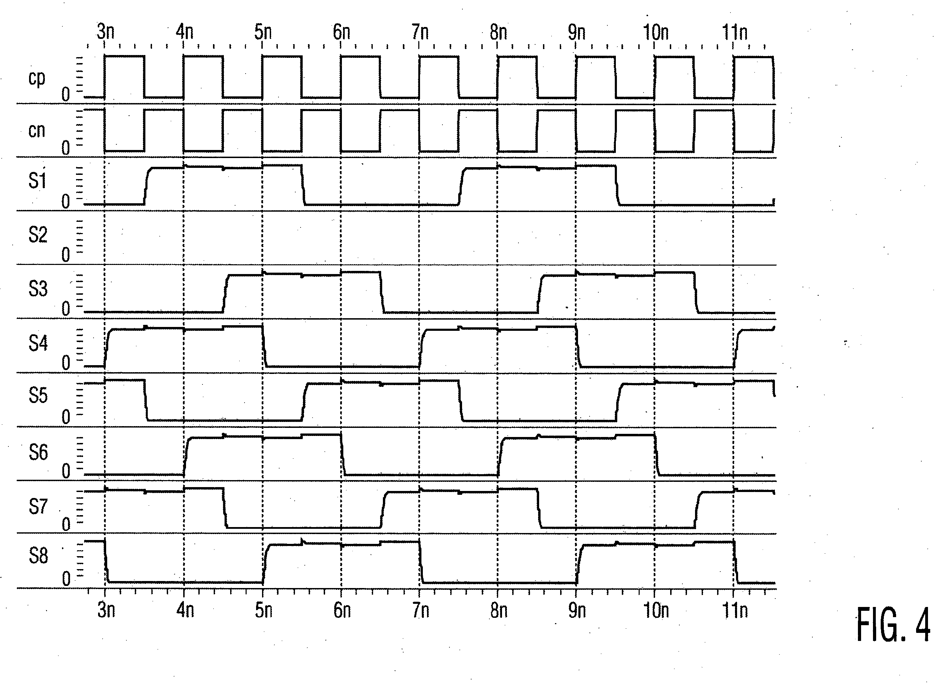

Fig. 4 represents the waveforms that were measured in a prototype implementation of the divide-by-four multi-phase frequency divider 400. It can be seen that output S1 is complemented by S5, output S2 is complemented by S6, output S3 is complemented by S7, and output S4 is complemented by S8. There is an even phase shift of 90-degrees amongst the phases.

It is possible to simplify divider 300 and use half the number of inverters and only the "cp" clock input. To do this, slightly different building blocks are used.

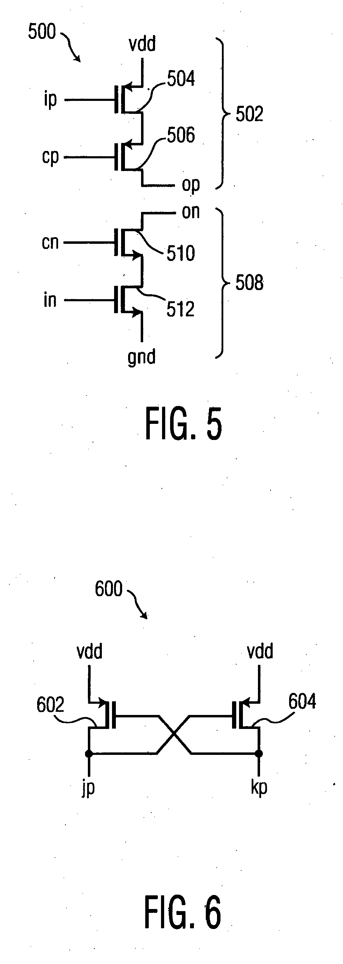

Fig. 5 represents a dynamic inverter embodiment of the present invention, and is referred to herein by the general reference numeral 500. The dynamic inverter 500 has a pmos storage half 502 comprising transistors 504 and 506 connected between a power rail (vdd) and a p-output (op). It includes a p-input (ip), a p-clock input (cp). The dynamic inverter 500 further includes an nmos storage half 508 comprising transistors 510 and 512 connected between an n-output (on) and ground (gnd). It further includes an n-input (in), an n-clock input (cn).

Fig. 6 represents a second building block, a pmos cross-latch embodiment of the present invention, and is referred to herein by the general reference numeral 600. The cross-latch 600 comprises cross-connected transistors 602 and 604. The two jp and kp nodes will force a latch of complementary values.

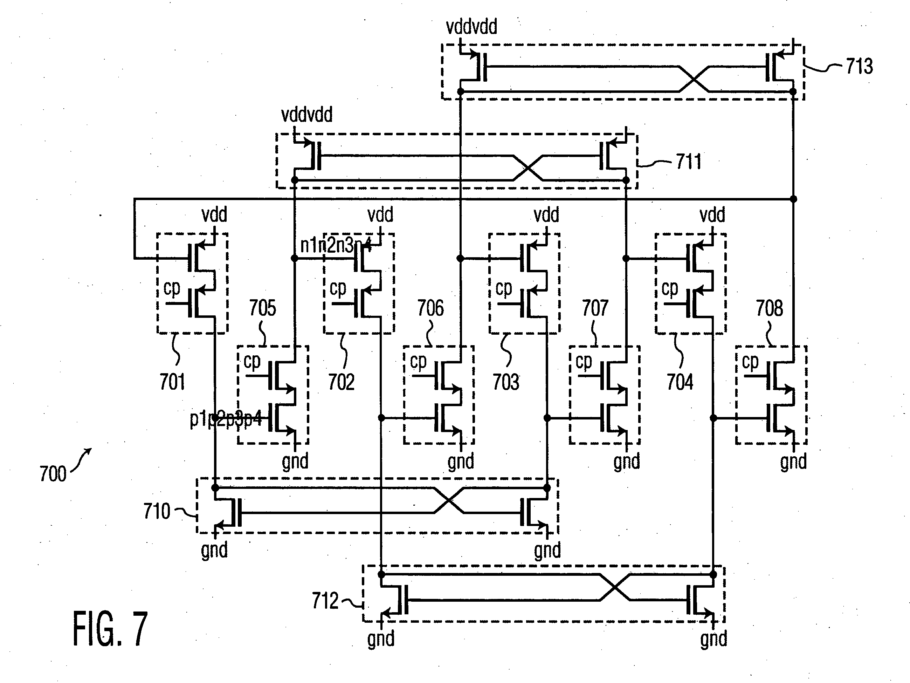

Fig. 7 represents a simplified divide-by-four multi-phase frequency divider embodiment of the present invention, and is referred to herein by the general reference numeral 700. It can be constructed with the building blocks illustrated in Figs. 2, 5, and 6, e.g., nmos cross-latch 200, pmos storage half 502, nmos storage half 508, and pmos cross-latch 600. The frequency divider 700 uses four dynamic inverters 500 (Fig. 5) split into dynamic pmos storage units 701-704, and dynamic nmos storage units 705-708. The output of each dynamic pmos storage 701-704 is connected to the input of the following dynamic nmos storage units 705-708, forming a ring. The nodes of the pmos storage output are labeled pl-p4, and those of the nmos storage output are labeled nl-n4.

Other even number divisions are possible, for any even integer "E", each divider requires E-number of dynamic inverters, E-number of nmos cross latches, and E-number of pmos cross latches. The pmos cross latches are connected to the output nodes of the nmos storage, and the nmos cross latches are connected to the output nodes of the pmos storage. If node pj is connected to one node of an nmos cross latch, then the other node of the cross latch should be connected to node p(E-j). The same applies to the pmos cross latch connections as well. For any input frequency "F", the output signals on node nl to nE run at the same frequency, F/E, with equal phase difference of (F/E)/2 between any two adjacent nodes.

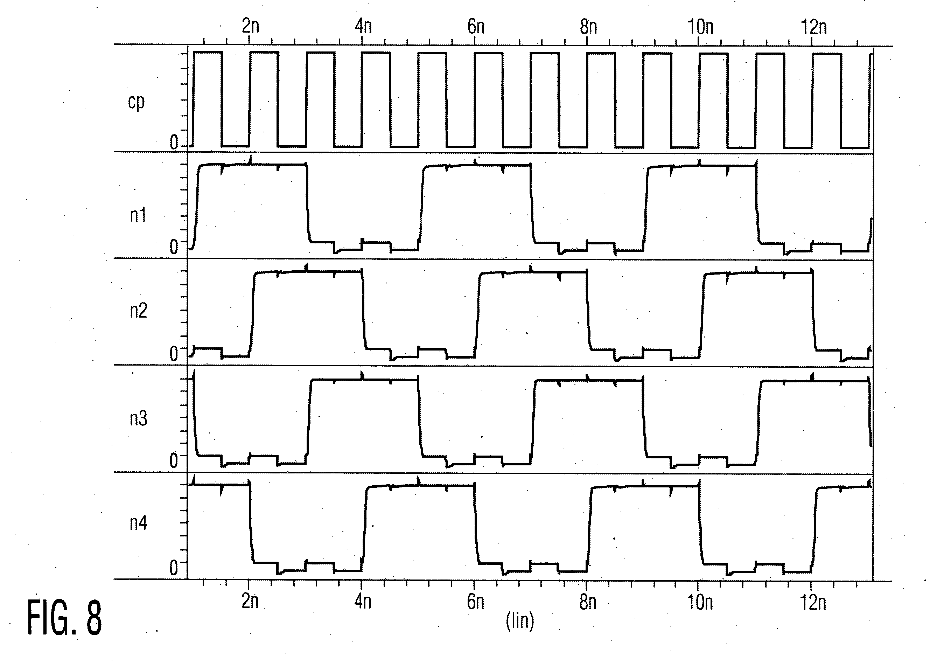

Fig. 8 represents the waveforms that were measured in a prototype implementation of the simplified divide-by-four multi-phase frequency divider 700. It can be seen that outputs n1-n4 have an even phase shift of 90-degrees amongst the four phases.

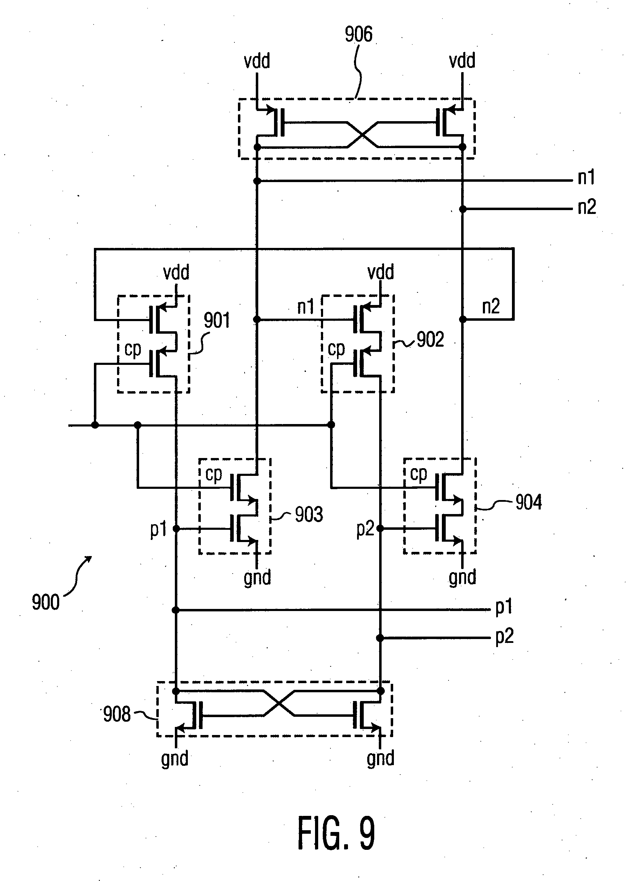

Fig. 9 represents a divide-by-two, quadrature-phase output, frequency divider embodiment of the present invention, and is referred to herein by the general reference numeral 900. It can be implemented with only twelve transistors. Divider 900 comprises a ring of pmos storage units 901 and 902, and nmos storage units 903 and 904. The divider clock input is applied to the "cp" input of each, and the multi-phase outputs are available as "n1", "n2", "p1", and "p2". A pmos cross-latch 906 and an nmos cross-latch 908 force the proper bit states around the ring.

Although particular embodiments of the present invention have been described and illustrated, such is not intended to limit the invention. Modifications and changes will no doubt become apparent to those skilled in the art, and it is intended that the invention only be limited by the scope of the appended claims.

## Claims

1. A frequency divider (300; 700; 900), comprising: an even number of dynamic inverters (100; 500) connected head-to-tail in a ring configuration; a plurality of cross-latches (200; 600) connected across the outputs of the dynamic inventers producing signals in phase opposition; a divider clock input connected in parallel to every one of the plurality of dynamic inverters; and divider multi-phase output provided in parallel from each output of a dynamic inverter, the frequency divider (300; 700; 900) further comprising: a first building block from which each of the plurality of dynamic inverters are constructed and comprising first and second pmos transistors (102, 104; 504, 506) and first and second nmos transistors (106, 108; 510, 512) connected in a totempole with an output taken at the junction of the second pmos and first nmos transistors, and having an input that is connected to the gate of the first pmos (102; 504) and second nmos transistors (108, 512), and a positive clock input (cp) that is connected to the gate of the second pmos transistor (104; 506), and negated clock input (cn) that is connected to the gate of the first nmos transistor (106, 510).

2. The frequency divider of Claim 1, further comprising: a second building block from which each of the plurality of cross-latches (200; 600) are constructed and comprising first and second nmos transistors (106, 108; 510, 512) cross-coupled with the gate of the first connected to the drain of the second, and the gate of the second connected to the drain of the first nmos transistor.

3. The frequency divider of Claim 1, further comprising: a divider clock differential input "ckip" connected to a "cp" input of a first one of the plurality of dynamic inverters and a "cn" of a second one of the plurality of dynamic inverters (100; 500), and alternating thereafter between pairs of stages.

4. The frequency divider of Claim 1, further comprising: a divider clock differential input "ckin" connected to a "cn" input of a first one of the plurality of dynamic inverters (100; 500) and a "cp" of a second one of the plurality of dynamic inverters, and alternating thereafter between pairs of stages.

5. The frequency divider of Claim 1, further comprising: a third building block pmos storage unit from which odd ones of the plurality of dynamic inverters (100; 500) are constructed and comprising first and second pmos transistors (102, 104; 504, 506) and first and second nmos transistors (108, 512), connected in a totempole with an "op" output, and having an "ip" input connected to the gate of the first pmos transistor (102; 504), and a positive clock input (cp) connected to the gate of the second pmos transistor (104; 506); and a fourth building block nmos storage unit from which even ones of the plurality of dynamic inverters (100; 500) are constructed and comprising first and second nmos transistors (106, 108; 510, 512) connected in a totempole with an "on" output, and having an "in" input connected to the gate of the second nmos transistor (108; 512), and a negated clock input (cn) connected to the gate of the first nmos transistor (106; 510); a fifth building block from which odd ones of the plurality of cross-latches (200; 600) are constructed and comprising nmos cross-latches connected to the outputs of pairs of the third building block pmos storage units; and a sixth building block from which even ones of the plurality of cross-latches (200; 600) are constructed and comprising pmos cross-latches connected to the outputs of pairs of the third building block nmos storage units.

6. A divide-by-two four-phase frequency divider, comprising: first through fourth inverters connected in a ring, wherein the first and third inverters are pmos storage units (701-704) having first and second pmos transistors (102, 104; 504, 506) connected in series with an inverter output (p1-p2), and the second and fourth inverters are nmos storage units (705-708) having first and second nmos transistors (106, 108; 510, 512) connected in series with an inverter output (n1-n2), and the gates of each first pmos transistor (102; 504) is connected to a corresponding previous nmos storage unit output (n1-n2), and the gates of each second nmos transistor (108; 512) is connected to a corresponding previous pmos storage unit output (p1-p2), and the gates of all the second pmos transistors (104; 506) and first nmos transistors (106; 510) are connected in parallel to a clock input (cp); an nmos cross-latch connected to hold each of the previous pmos storage unit outputs (p1-p2) after each input clock (cp); and a pmos cross-latch connected to hold each of the previous nmos storage unit outputs (n1-n2) after each input clock (cp).; wherein, a divider multi-phase output provided in parallel from each inverter outputs (p1, p2, n1, n2).

7. A method of generating multi-phase signals comprising: providing a frequency divider (300; 700; 900), the frequency divider comprising: an even number of dynamic inverters (100; 500) connected head-to-tail in a ring configuration; a plurality of cross-latches (200; 600) connected across the outputs of the dynamic inventers producing signals in phase opposition; a divider clock input connected in parallel to every one of the plurality of dynamic inverters; and divider multi-phase output provided in parallel from each output of a dynamic inverter, the frequency divider (300; 700; 900) further comprising: a first building block from which each of the plurality of dynamic inverters are constructed and comprising first and second pmos transistors (102, 104; 504, 506) and first and second nmos transistors (106, 108; 510, 512) connected in a totempole with an output taken at the junction of the second pmos and first nmos transistors, and having an input that is connected to the gate of the first pmos (102; 504) and second nmos transistors(108, 512), and a positive clock input (cp) that is connected to the gate of the second pmos transistor (104; 506), and negated clock input (cn) that is connected to the gate of the first nmos transistor (106, 510), wherein the output of each dynamic converter provides a multi-phase frequency output evenly distributed in phase with its peers.

## Patentansprüche

1. Ein Frequenzteiler (300: 700; 900), umfassend: eine gerade Zahl von dynamischen Invertern (100; 500), die in einer Kopf-Fuß-Ringkonfiguration verbunden sind; eine Vielzahl von Cross Latches (200; 600), die über die Ausgänge der dynamischen Inverter, welche Signale in Phasenopposition erzeugen, verbunden sind; einen Frequenzteiler-Takteingang, der mit jedem aus der Vielzahl von dynamischen Invertern parallel geschalten ist; und einen Frequenzteiler-Multiphasenausgang, der von jedem Ausgang eines dynamischen Inverters parallel bereitgestellt wird, wobei der Frequenzteiler (300; 700; 900) überdies Folgendes umfasst: einen ersten Baustein, aus dem jeder aus der Vielzahl von dynamischen Invertern konstruiert ist, und der erste und zweite pMOS-Transistoren (102, 104; 504, 506) sowie erste und zweite nMOS-Transistoren (106, 108; 510, 512) umfasst, die in einem Totem-Pole mit einem Ausgang verbunden sind, welcher am Übergang der zweiten pMOS- und ersten nMOS-Tansistoren übernommen wird, und einen Eingang aufweist, der mit dem Gate der ersten pMOS- (102; 504) und der zweiten nMOS-Transistoren (108, 512) verbunden ist, und einen positiven Takteingang (cp), der mit dem Gate des zweiten pMOS-Transistors (104; 506) verbunden ist, sowie einen negierten Takteingang (cn), der mit dem Gate des ersten nMOS-Transistors (106, 510) verbunden ist.

2. Der Frequenzteiler von Anspruch 1, überdies umfassend: einen zweiten Baustein, aus dem jeder aus der Vielzahl von Cross Latches (200; 600) konstruiert ist, und der erste und zweite nMOS-Transistoren (102, 104; 504, 506) umfasst, die kreuzgekoppelt sind mit dem Gate des ersten nMOS-Transistors, das mit dem Ablauf des zweiten nMOS-Transistors verbunden ist, und dem Gate des zweiten nMOS-Transistors, das mit dem Ablauf des ersten nMOS-Transistors verbunden ist.

3. Der Frequenzteiler von Anspruch 1, überdies umfassend: einen Differential-Eingang "ckip" des Frequenzteiler-Taktgebers, der mit einem "cp" Eingang eines ersten aus der Vielzahl von dynamischen Invertern und einem "cn" eines zweiten aus der Vielzahl von dynamischen Invertern (100; 500) verbunden ist, und danach zwischen Paaren von Stadien abwechselt.

4. Der Frequenzteiler von Anspruch 1, überdies umfassend: einen Differential-Eingang "ckin" des Frequenzteiler-Taktgebers, der mit einem "cn" Eingang eines ersten aus der Vielzahl von dynamischen Invertern (100; 500) und einem "cp" eines zweiten aus der Vielzahl von dynamischen Invertern verbunden ist, und danach zwischen Paaren von Stadien abwechselt.

5. Der Frequenzteiler von Anspruch 1, überdies umfassend: eine dritte Baustein-pMOS-Speichereinheit, von der ungerade aus der Vielzahl von dynamischen Invertern (100; 500) konstruiert sind, und die erste und zweite pMOS-Transistoren (102, 104; 504, 506) und erste und zweite nMOS-Transistoren (108, 512) umfasst, die in einem Totem-Pole mit einem "op" Ausgang verbunden sind und einen "ip" Eingang aufweisen, der mit dem Gate des ersten pMOS-Transistors (102; 504) verbunden ist, sowie einen positiven Takteingang (cp), der mit dem Gate des zweiten nMOS-Transistors (104; 506) verbunden ist; und eine vierte Baustein-nMOS-Speichereinheit, von der gerade aus der Vielzahl von dynamischen Invertern (100; 500) konstruiert sind, und die erste und zweite nMOS-Transistoren (106, 108; 510, 512) umfasst, welche in einem Totem-Pole mit einem "on" Ausgang verbunden sind und einen "in" Eingang aufweisen, der mit dem Gate des zweiten pMOS-Transistors (108; 512) verbunden ist, und einen negierten Takteingang (cn), der mit dem Gate des ersten nMOS-Transistors (106; 510) verbunden ist; einen fünften Baustein, von dem ungerade aus der Vielzahl von Cross Latches (200;600) konstruiert sind, und der nMOS-Cross Latches umfasst, die mit den Ausgängen von Paaren der dritten Baustein-pMOS-Speichereinheiten verbunden sind; und einen sechsten Baustein, von dem gerade aus der Vielzahl von Cross Latches (200; 600) konstruiert sind, und der pMOS-Cross Latches umfasst, die mit den Ausgängen von Paaren der dritten Baustein-nMOS-Speichereinheiten verbunden sind.

6. Ein durch zwei geteilter Vierphasen-Frequenzteiler, umfassend: erste bis vierte Inverter, die in einem Ring verbunden sind, wobei die ersten und dritten Inverter pMOS-Speichereinheiten (701-704) sind, die erste und zweite pMOS-Transistoren (102, 104; 504, 506) aufweisen, welche mit einem Inverter-Ausgang (p1-p2) in Reihe geschaltet sind, und die zweiten und vierten Inverter nMOS-Speichereinheiten (705-708) sind, welche erste und zweite nMOS-Transistoren (106, 108; 510, 512) aufweisen, die wiederum mit einem Inverterausgang (n1-n2) in Reihe geschaltet sind, und wobei die Gates von jedem ersten pMOS-Transistor (102; 504) mit einem entsprechenden vorherigen nMOS-Speichereinheitsausgang (n1-n2) verbunden sind, und die Gates von jedem zweiten nMOS-Transistor (108; 512) mit einem entsprechenden vorherigen pMOS-Speichereinheitsausgang (p1-p2) verbunden sind, und die Gates von allen zweiten pMOS-Transistoren (104; 506) und ersten nMOS-Transistoren (106; 510) mit einer Takteingabe (cp) parallel geschaltet sind; ein nMOS-Cross Latch, das verbunden ist, um jeden der vorherigen pMOS-Speichereinheitsausgänge (p1-p2) nach jedem Eingangstaktgeber (cp) zu halten; sowie ein pMOS-Cross Latch, das verbunden ist, um jeden der vorherigen nMOS-Speichereinheitsausgänge (n1-n2) nach jedem Eingabetaktgeber (cp) zu halten; worin ein Frequenzteiler-Multiphasenausgang von jedem der Inverterausgänge (p1, p2, n1, n2) parallel bereitgestellt wird.

7. Ein Verfahren zum Erzeugen von Multiphasen-Signalen, umfassend: Bereitstellen eines Frequenzteilers (300; 700; 900), wobei der Frequenzteiler Folgendes umfasst: eine gerade Zahl von dynamischen Invertern (100; 500), die in einer Kopf-Fuß-Ringkonfiguration verbunden sind; eine Vielzahl von Cross Latches (200; 600), die über die Ausgänge der dynamischen Inverter, welche Signale in Phasenopposition erzeugen, verbunden sind; einen Frequenzteiler-Takteingang, der mit jedem aus der Vielzahl von dynamischen Invertern parallel geschaltet ist; und einen Frequenzteiler-Multiphasenausgang, der von jedem Ausgang eines dynamischen Inverters parallel bereitgestellt wird, wobei der Frequenzteiler (300; 700; 900) überdies Folgendes umfasst: einen ersten Baustein, von dem jeder aus der Vielzahl von dynamischen Invertern konstruiert ist und erste und zweite pMOS-Transistoren (102, 104; 504, 506) sowie erste und zweite nMOS-Transistoren (106, 108; 510, 512) umfasst, die in einem Totem-Pole mit einem Ausgang verbunden sind, der am Übergang der zweiten pMOS- und ersten nMOS-Tansistoren übernommen wird, und einen Eingang aufweist, der mit dem Gate der ersten pMOS-(102; 504) und zweiten nMOS-Transistoren (108, 512) verbunden ist, und einen positiven Takteingang (cp), der mit dem Gate des zweiten pMOS-Transistors (104; 506) verbunden ist, und einen negierten Takteingang (cn), der mit dem Gate des ersten nMOS-Transistors (106, 510) verbunden ist, worin der Ausgang jedes dynamischen Konverters einen Multiphasen-Frequenzausgang bereitstellt, der gleichmäßig phasengleich mit seinen Peers verteilt ist.

## Revendications

1. Diviseur de fréquence (300, 700, 900), comprenant : un nombre pair d'inverseurs dynamiques (100, 500) connectés tête-bêche dans une configuration en anneau ; une pluralité de verrous transversaux (200, 600) connectés aux sorties des inverseurs dynamiques produisant des signaux en opposition de phase ; une entrée de diviseur d'horloge connectée en parallèle à chacun de la pluralité d'inverseurs dynamiques ; et une sortie de diviseur polyphasé fournie en parallèle à partir de chaque sortie d'un inverseur dynamique, le diviseur de fréquence (300, 700, 900) comprenant en outre : un premier bloc fonctionnel à partir duquel chacun de la pluralité d'inverseurs dynamiques est construit et comprenant des premiers et deuxièmes transistors à canal P (102, 104, 504, 506) et des premiers et deuxièmes transistors à canal N (106, 108, 510, 512) connectés dans un totem pôle avec une sortie prise au point de jonction du deuxième transistor à canal P et du premier transistor à canal N, et ayant une entrée qui est connectée à la porte du premier transistor à canal P (102, 504) et du deuxième transistor à canal N (108, 512), et une entrée d'horloge positive (cp) qui est connectée à la porte du deuxième transistor à canal P (104; 506), et une entrée d'horloge inversée (cn) qui est connectée à la porte du premier transistor à canal N (106, 510).

2. Diviseur de fréquence selon la revendication 1, comprenant en outre : un deuxième bloc fonctionnel à partir duquel chacun de la pluralité de verrous transversaux (200, 600) est construit et comprenant des premiers et deuxièmes transistors à canal N (106, 108, 510, 512) couplés transversalement avec la porte du premier connecté au drain du deuxième, et la porte du deuxième connectée au drain du premier transistor à canal N.

3. Diviseur de fréquence selon la revendication 1, comprenant en outre : une entrée différentielle « ckip » de diviseur d'horloge connectée à une entrée « cp » d'un premier de la pluralité d'inverseurs dynamiques et une « cn » d'un deuxième de la pluralité d'inverseurs dynamiques (100, 500), et en alternant ensuite entre des paires d'étages.

4. Diviseur de fréquence selon la revendication 1, comprenant en outre : une entrée différentielle « ckin » de diviseur d'horloge connectée à une entrée « cn » d'un premier de la pluralité d'inverseurs dynamiques (100, 500) et une « cp » d'un deuxième de la pluralité d'inverseurs dynamiques, et en alternant ensuite entre des paires d'étages.

5. Diviseur de fréquence selon la revendication 1, comprenant en outre : une troisième unité de stockage de transistor à canal P de bloc fonctionnel à partir de laquelle les inverseurs dynamiques impairs de la pluralité d'inverseurs dynamiques (100, 500) sont construits et comprenant des premiers et deuxièmes transistors à canal P (102, 104, 504, 506) et des premiers et deuxièmes transistors à canal N (108, 512), connectés à un totem pôle avec une sortie « op », et ayant une entrée « ip » connectée à la porte du premier transistor à canal P (102, 504), et une entrée d'horloge positive (cp) connectée à la porte du deuxième transistor P (104, 506) ; et une quatrième unité de stockage de transistor à canal N de bloc fonctionnel à partir de laquelle les inverseurs pairs de la pluralité d'inverseurs dynamiques (100, 500) sont construits et comprenant des premiers et deuxièmes transistors à canal N (106, 108, 510, 512) connectés à un totem pôle avec une sortie « on », et une entrée « ip » connectée à la porte du deuxième transistor à canal N (108, 512), et une entrée d'horloge inversée (cn) connectée à la porte du premier transistor à canal N (106, 510) ; un cinquième bloc fonctionnel à partir duquel les verrous transversaux impairs de la pluralité de verrous transversaux (200, 600) sont construits et comprenant des verrous transversaux de transistor à canal N connectés aux sorties des paires des troisièmes unités de stockage de transistor à canal P ; et un sixième bloc fonctionnel à partir duquel, les verrous transversaux pairs de la pluralité de verrous transversaux (200, 600) sont construits et comprenant des verrous transversaux de transistor à canal P connectés aux sorties des paires des troisièmes unités de stockage de transistor à canal N.

6. Diviseur de fréquence tétraphasé à division par deux, comprenant : des inverseurs du premier au quatrième connectés dans un anneau, dans lequel le premier et le troisième inverseur sont des unités de stockage de transistor à canal P (701 - 704) ayant des premiers et deuxièmes transistors à canal P (102, 104, 504, 506) connectés en série avec une sortie d'inverseur (p1 - p2), et le deuxième et le quatrième inverseur sont des unités de stockage de transistor à canal N (705 - 708) ayant des premiers et deuxièmes transistors à canal N (106, 108, 510, 512) connectés en série avec une sortie d'inverseur (n1 - n2), et les portes de chaque premier transistor à canal P (102, 504) sont connectées à une sortie de l'unité précédente de stockage de transistor à canal N correspondant (n1 - n2), et les portes de chaque deuxième transistor à canal N (108, 512) sont connectées à une sortie de l'unité précédente de stockage de transistor à canal P correspondant (p1 - p2), et les portes de tous les deuxièmes transistors à canal P (104, 506) et des premiers transistors à canal N (106, 510) sont connectées en parallèle à une entrée d'horloge (cp) ; un verrou transversal de transistor à canal N connecté pour maintenir chacune des sorties de l'unité de stockage de transistor à canal P précédentes (p1 - p2) après chaque horloge d'entrée (cp) ; et un verrou transversal de transistor à canal P connecté pour maintenir chacune des sorties des unités de stockage de transistor à canal N précédentes (n1 - n2) après chaque horloge d'entrée (cp) ; dans lequel, une sortie polyphasée de diviseur est fournie en parallèle à partir de chacune des sorties de l'inverseur (p1, p2, n1, n2).

7. Procédé de génération de signaux polyphasés comprenant : la fourniture d'un diviseur de fréquence (300, 700, 900), le diviseur de fréquence comprenant : un nombre pair d'inverseurs dynamiques (100, 500) connectés tête-bêche dans une configuration en anneau ; une pluralité de verrous transversaux (200, 600) connectés entre les sorties des inventeurs dynamiques qui produisent des signaux en opposition de phase ; une entrée de diviseur d'horloge connectée en parallèle à chacun de la pluralité d'inverseurs dynamiques ; et une sortie de diviseur polyphasé fournie en parallèle à partir de chaque sortie d'un inverseur dynamique, le diviseur de fréquence (300, 700, 900) comprenant en outre : un premier bloc fonctionnel à partir duquel chacun de la pluralité d'inverseurs dynamiques est construit et comprenant des premiers et deuxièmes transistors à canal P (102, 104, 504, 506) et des premiers et deuxièmes transistors à canal N (106, 108, 510, 512) connectés dans un totem pôle avec une sortie prise au point de jonction du premier transistor à canal P et du deuxième transistor à canal N, et ayant une entrée qui est connectée à la porte du premier transistor à canal P (102, 504) et au deuxième transistor à canal N (108, 512), et une horloge d'entrée positive (cp) qui est connectée à la porte du deuxième transistor à canal P (104, 506), et une entrée d'horloge inversée (cn) qui est connectée à la porte du premier transistor à canal N (106, 510), dans lequel la sortie de chaque convertisseur dynamique fournit une sortie de fréquence polyphasée répartie uniformément en phase avec ses homologues.
